(19) Europäisches Patentamt
European Patent Office
Office européen des brevets

(11) **EP 1 636 906 B1**

(12) **EUROPÄISCHE PATENTSCHRIFT**

(45) Veröffentlichungstag und Bekanntmachung des Hinweises auf die Patenterteilung:
**21.01.2009 Patentblatt 2009/04**

(21) Anmeldenummer: **04723155.0**

(22) Anmeldetag: **25.03.2004**

(51) Int Cl.:
**H03M 1/06** (2006.01)

(86) Internationale Anmeldenummer:
**PCT/DE2004/000616**

(87) Internationale Veröffentlichungsnummer:
**WO 2004/112253 (23.12.2004 Gazette 2004/52)**

(54) **ELEKTRONISCHER SCHALTKREIS ZUR MESSGRÖSSENERFASSUNG**

ELECTRONIC CIRCUIT FOR MEASURED PARAMETER RECORDING

CIRCUIT ELECTRONIQUE POUR L'ENREGISTREMENT DE GRANDEURS DE MESURE

(84) Benannte Vertragsstaaten:
**DE FR IT**

(30) Priorität: **23.05.2003 DE 10323498**

(43) Veröffentlichungstag der Anmeldung:
**22.03.2006 Patentblatt 2006/12**

(73) Patentinhaber: **ROBERT BOSCH GMBH**
**70442 Stuttgart (DE)**

(72) Erfinder:
• **KIRSCHNER, Manfred**
**70197 Stuttgart (DE)**
• **SCHWEINFURTH, Reiner**
**75031 Eppingen (DE)**
• **MEIWES, Johannes**
**71706 Markgroeningen (DE)**
• **GROSSMANN, Alex**
**76593 Gernsbach (DE)**
• **KLEIN, Eberhard**
**73207 Plochingen (DE)**
• **TEPASS, Bernd**
**71717 Beilstein (DE)**
• **BAUMANN, Torsten**
**75031 Eppingen-Adelshofen (DE)**

(56) Entgegenhaltungen:
**DE-A- 4 220 012       DE-A- 19 629 747**

EP 1 636 906 B1

**Beschreibung**

Die Erfindung betrifft einen elektronischen Schaltkreis zur Messgrößenerfassung.

Stand der Technik

Die DE 42 20 012 A1 zeigt einen ratiometrischen Konverter, bei dem die Eingangsspannung einer Lastzelle mit einer internen Referenz verglichen wird. Insbesondere zeigt die DE 42 20 012 A1 einen elektronischen Schaltkreis zur Messgrößenerfassung, umfassend:

- mindestens eine Sensoreinrichtung zum Bereitstellen eines analogen Messsignals, welches eine von der Sensoreinrichtung erfasste Messgröße repräsentiert;
- eine erste Signalerfassungseinrichtung mit einem ersten Analog/Digital-Wandler zum Digitalisieren des analogen Messsignals, sowie
- eine Spannungsversorgungseinrichtung mit einer ersten Spannungsquelle zum Bereitstellen einer ersten Versorgungsspannung für die Sensoreinrichtung mit einer Ungenauigkeit und mit einer zweiten Spannungsquelle zum Bereitstellen einer zweiten Spannungsquelle zum Bereitstellen einer Referenzspannung für die Signalerfassungseinrichtung, wobei sich die erwähnte Ungenauigkeit auf das Messsignal überträgt, wobei
- die Signalerfassungseinrichtung eine Korrektureinrichtung auf zum Kompensieren der Auswirkungen der genannten Ungenauigkeit auf das digitalisierte Messsignal aufweist.

Die DE 196 29 747 A1 zeigt eine Sensoreinrichtung mit der Erzeugung eines ratiometrischen Signals. Die Sensoreinrichtung umfasst eine Korrektureinrichtung, die ein Korrektursignal in Abhängigkeit von Referenzströmen erzeugt.

Aus dem Stand der Technik sind elektronische Schaltkreise zur Messgrößenerfassung grundsätzlich bekannt. Derartige Schaltkreise weisen üblicherweise mindestens eine Sensoreinrichtung auf zum Bereitstellen eines analogen Messsignals, welches eine von der Sensoreinrichtung erfassten Messgröße repräsentiert. Darüber hinaus weisen derartige elektronische Schaltkreise eine Signalerfassungseinrichtung auf, welche insbesondere im Kraftfahrzeugbereich in der Regel in einem Steuergerät integriert ist. Die Signalerfassungseinrichtung weist üblicherweise einen ersten Analog/Digital-Wandler zum Digitalisieren des analogen Messsignals auf. Darüber hinaus ist diesen elektronischen Schaltkreisen eine Spannungsversorgungseinrichtung zugeordnet zum Bereitstellen einer Versorgungsspannung für sowohl die Sensoreinrichtung wie auch für die Signalerfassungseinrichtung.

Traditionell werden sowohl die Sensoreinrichtung wie auch die Signalerfassungseinrichtung aus derselben Spannungsquelle mit jeweils betraglich gleichen Versorgungsspannungen betrieben, wobei diese Versorgungsspannungen jeweils auch dieselbe Fehlertoleranz beziehungsweise Ungenauigkeit aufweisen. Aufgrund dieser Gleichheit der Ungenauigkeiten in den Spannungsversorgungssignalen spricht man auch von gleichlaufende oder ratiometrischer Spannungsversorgung.

Es ist grundsätzlich davon auszugehen, dass sich die Ungenauigkeiten beziehungsweise Schwankungen in der Versorgungsspannung in der Sensoreinrichtung auch auf das von ihr erzeugte analoge Messsignal auswirken. Aufgrund der nachfolgenden Digitalisierung dieses analogen Messsignals mit einem Analog/Digital-Wandler, welcher mit einer gleich laufenden, das heißt dieselben Ungenauigkeiten aufweisenden Versorgungsspannung betrieben wird wie die Sensoreinrichtung, werden diese Ungenauigkeiten in dem am Ausgang des Analog/Digital-Wandlers anstehenden digitalisierten Messsignals kompensiert. Schwankungen in der Versorgungsspannung haben also bei traditioneller ratiometrischer Spannungsversorgung von sowohl der Sensoreinrichtung wie auch der Signalerfassungseinrichtung keine Auswirkungen auf das Messsignal. Der Grund dafür liegt darin, dass diese eventuellen Schwankungen gleichermaßen sowohl an der Sensoreinrichtung wie auch an der Signalerfassungseinritüng auftreten und deshalb nicht auffällig werden beziehungsweise sich herausmitteln.

Zukünftige Steuergeräte beziehungsweise Signalerfassungseinrichtungen werden voraussichtlich mit einer betraglich geringeren Versorgungsspannung als den heute üblichen 5 V betrieben werden. Damit werden auch die in den Signalerfassungseinrichtungen enthaltenen Komponenten wie Mikrocontroller oder Analog/DigitalWandler, insbesondere embedded Analog/Digital-Wandler, mit der geringeren Versorgungsspannung, zum Beispiel 3,3 V betrieben werden. Gleichzeitig werden jedoch zumindest für eine Übergangszeit noch die bisherigen Sensoreinrichtungen weiterverwendet werden, welche nach wie vor mit vorzugsweise 5 V betrieben werden. Dies hat zur Folge, dass unterschiedliche Spannungsquellen für die unterschiedlichen Versorgungsspannungen für die Sensoreinrichtung und die Signalerfassungseinrichtung bereitgestellt werden müssen. Dabei besteht die große Gefahr, dass die Ratiometrie in der Spannungsversorgung, das heißt die Gleichartigkeit der Ungenauigkeiten der beiden Versorgungsspannungen und damit auch der oben beschriebene Vorteil der Kompensation der Ungenauigkeiten in dem Messsignal verloren geht. Der Grund dafür ist darin zu sehen, dass die unterschiedlichen Spannungsquellen für die einzelnen Versorgungsspannungen grundsätzlich individuell verschiedene Ungenauigkeiten bezüglich ihrer Spannungsversorgung aufweisen können.

Ausgehend von diesem Stand der Technik ist es die Aufgabe der Erfindung, einen bekannten elektronischen Schaltkreis zur Messdatenerfassung, derart weiterzubilden,dass auch bei Versorgung der Sensoreinrichtung und der Signalerfassungseinrichtung mit jeweiligen Versorgungsspannungen von unterschiedlicher Genauigkeit eine Auswirkung dieser unterschiedlichen Genauigkeiten auf das von der Signalerfassungseinrichtung ausgegebene Messsignal verhindert wird.

Diese Aufgabe wird durch den Gegenstand des Patentanspruchs 1 gelöst. Demnach wird vorgeschlagen, dass die Signalerfassungseinrichtung eine Korrektureinrichtung aufweist zum Kompensieren der Auswirkungen der Ungenauigkeiten x1 und x2 auf das digitalisierte Messsignal im Ansprechen auf ein digitalisiertes, die Ungenauigkeit der ersten Versorgungsspannung repräsentierendes Spannungssignal und zum Ausgeben eines aus der Kompensation resultierenden kompensierten digitalen Messsignals.

Es sei an dieser Stelle besonders betont, dass das analoge Messsignal von der mit der ersten Versorgungsspannung, die eine Ungenauigkeit von x1 aufweist, betriebenen Sensoreinrichtung bereitgestellt wird. Es erfolgt dann eine Digitalisierung des analogen Messsignals durch den ersten Analog/Digital-Wandler, welcher mit einer zweiten, eine Ungenauigkeit von x2 aufweisenden Versorgungsspannung betrieben wird.

Vorteile der Erfindung

Die erfindungsgemäfie Korrektureinrichtung bewirkt vorteilhafterweise auch bei unterschiedlichen Ungenauigkeiten x1 und x2 der genannten Versorgungsspannungen eine Kompensation der Auswirkungen dieser Ungenauigkeiten in dem Messsignal.

Die Auswirkungen der Ungenauigkeiten beziehungsweise Schwankungen der Versorgungsspannungen bestehen insbesondere in entsprechenden Ungenauigkeiten des Messsignals.

Für den Fall, dass die erste Versorgungsspannung zum Betrieb der Sensoreinrichtung betraglich größer ist als die zweite Versorgungsspannung zum Betrieb der Signalerfassungseinrichtung kann erfindungsgemäß ein vorzugsweise hoch genauer Spannungsteiler vorgesehen sein, um das Spannungssignal durch Teilung aus der ersten Versorgungsspannung zu generieren. Auf diese Weise wird gewährleistet, dass das Spannungssignal von den mit der niedrigeren zweiten Versorgungsspannung betriebenen Komponenten innerhalb der Signalerfassungseinrichtung richtig ausgewertet, und verarbeitet werden kann.

Wiederum in den Fällen, dass die Sensoreinrichtung mit einer betraglich größeren Versorgungsspannung als die Signalerfassungseinrichtung betrieben werden sollte, kann es erfindungsgemäß vorgesehen sein, dass von der Sensoreinrichtung erzeugte analoge Messsignal bezüglich seiner Amplitude zu begrenzen. Diese Begrenzung kann zum einen durch eine in der Sensoreinrichtung vorgesehene Kennlinienbegrenzungseinrichtung realisiert werden. Alternativ dazu besteht eine zweite Möglichkeit der Amplitudenbegrenzung für das analoge Messsignal darin, der Sensoreinrichtung ohne Kennlinienbegrenzungseinrichtung eine Spannungsteilerschaltung nachzuschalten. Diese Spannungsteilerschaltung ist vorzugsweise nicht nur im Hinblick auf eine gewünschte Amplitude des analogen Messsignal, sondern auch im Hinblick auf weitere Erfordernisse wie zum Beispiel Impedanzanpassung an die Sensoreinrichtung ausgebildet. Natürlich kann eine Begrenzung der Amplitude des Messsignals auch durch eine Kombination aus Kennlinienbegrenzungseinrichtung und Spannungsteilerschaltung realisiert sein.

Die Korrektureinrichtung kann erfindungsgemäß und vorteilhafterweise in der Weise ausgebildet sein, dass sie die Berechnung eines Normierungsfaktors N vorsieht, mit dem das digitalisierte Messsignal multipliziert wird, um das kompensierte digitale Messsignal zu erhalten. Die Berechnung des Normierungfaktors N erfolgt durch eine Division von Werten des digitalisierten Messsignals durch Werte eines digitalisierten Spannungssignals, welches die Ungenauigkeit der ernsten Versorgungsspannung, mit welcher die Sensoreinrichtung betrieben wird, repräsentiert.

Zeichnungen

Die Erfindung wird nachfolgend detailliert in Form von verschiedenen Ausfiihrungsbeispielen unter Bezugnahme auf die der Beschreibung beigefügten Figuren näher erläutert, wobei

Figur 1 einen elektronischen Schaltkreis zur Messdatenerfassung;

Figur 2 den Aufbau einer erfindungsgemäß Korrektureinrichtung;

Figur 3 ein Ausfiihrungsbeispiel für den elektronischen Schaltkreis gemäß der Erfindung;

Figur 4a ein erstes Ausfiihrungsbeispiel für eine Spannungsteilerschaltung;

Figur 4b ein zweites Ausführungsbeispiel für die Spannungsteilerschaltung; und

Figur 4c ein drittes Ausfiihrungsbeispiel für die Spannungsteilerschaltung zeigt.

Beschreibung der Ausführungsbeispiele

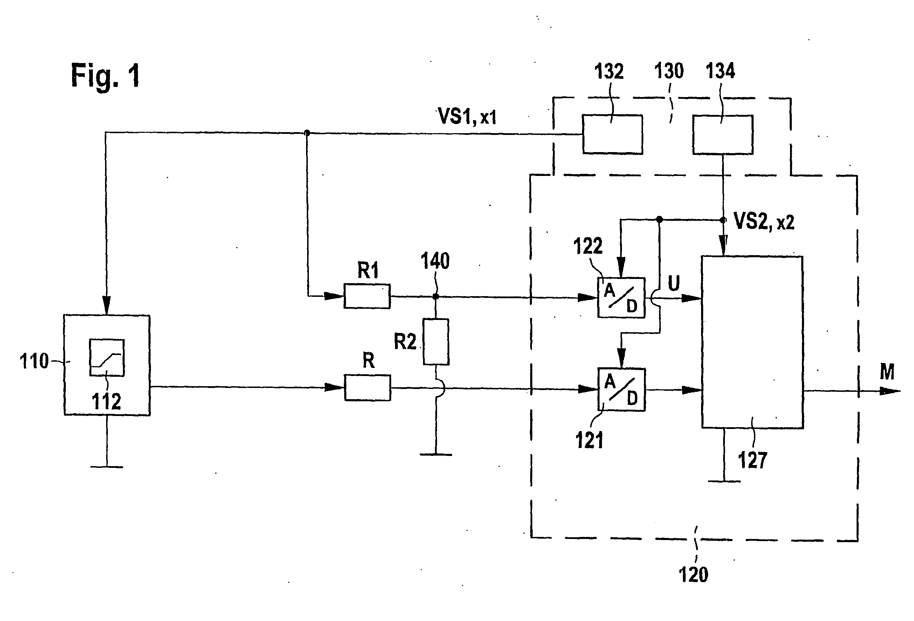

Figur 1 zeigt einen elektronischen Schaltkreis zur Messdatenerfassung. Er umfasst mindestens eine Sensoreinrichtung 110 zum Bereitstellen eines analogen Messsignals, welches eine von der Sensoreinrichtung 110 erfasste Messgröße repräsentiert. Weiterhin umfasst der elektronische Schaltkreis eine Signalerfassungseinrichtung 120, welche vorzugsweise in einem Steuergerät zum Beispiel für ein Kraftfahrzeug integriert ist. Diese Signalerfassungseinrichtung 120 umfasst insbesondere einen ersten Analog/Digital-Wandler 121 zum Digitalisieren des von der Sensoreinrichtung 110 bereitgestellten analogen Messsignals. Darüber hinaus umfasst der elektronische Schaltkreis eine Spannungsversorgungseinrichtung 130 mit einer ersten Spannungsquelle 132 zum Bereitstellen einer ersten Versorgungsspannung VS1 für die Sensoreinrichtung 110, wobei diese erste Versorgungsspannung VS1 mit einer Ungenauigkeit, das heißt insbesondere mit Spannungsschwankungen von x1, vorzugsweise angegeben in Prozent, behaftet ist. Darüber hinaus umfasst die Spannungsversorgungseinrichtung eine zweite Spannungsquelle 134 zum Bereitstellen einer zweiten Versorgungsspannung VS2, welche mit einer Ungenauigkeit von x2, vorzugsweise ebenfalls angegeben in Prozent, behaftet ist.

Die Signalerfassungseinrichtung 120 umfasst weiterhin eine Korrektureinrichtung 127. Diese dient zum Kompensieren der Ungenauigkeiten x1 und/oder x2 beziehungsweise von deren Auswirkungen in dem digitalisierten Messsignal. An ihrem Ausgang erzeugt diese Korrektureinrichtung dann ein kompensiertes digitales Messsignal M.

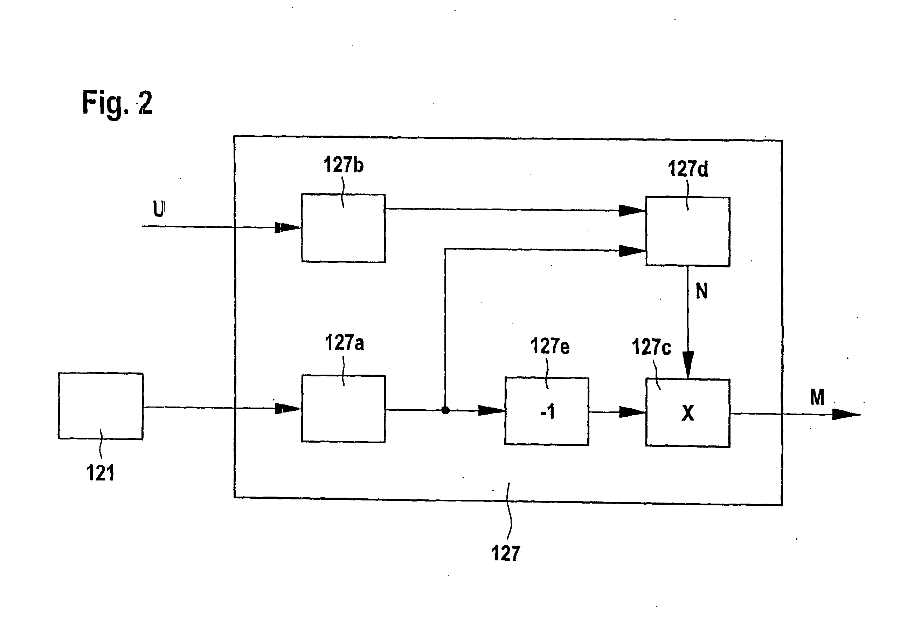

Der Aufbau und die Funktionsweise der Korrektureinrichtung 127 sind in Figur 2 veranschaulicht. Demnach umfasst die Korrektureinrichtung ein erstes Speicherelement 127a, zum Beispiel ein Register, zum Abspeichern von aktuellen Ausgangswerten des ersten Analog/Digital-Wandlers 121, das heißt von aktuellen Werten des digitalisierten Messsignals. Weiterhin umfasst die Korrektureinrichtung 127 ein zweites Speicherelement 127b, zum Beispiel ein zweites Register zum Abspeichern von aktuellen Werten eines digitalisierten Spannungssignals, welches die Ungenauigkeit x1 der ersten Versorgungsspannung VS1 repräsentiert. "Aktuelle Werte" meinen in beiden Fällen Werte zum Zeitpunkt n. Die Inhalte des ersten und des zweiten Speicherelements 127a und 127b zum Zeitpunkt n werden einer Normierungseinrichtung 127d zugeführt. Die Nörmierungseinrichtung 127d berechnet aus diesen Eingangswerten einen Normierungsfaktor N, indem sie den Inhalt des ersten Speicherelementes 127a zum Zeitpunkt n durch den Inhalt des zweiten Speicherelementes 127b zum Zeitpunkt n dividiert. Der auf diese Weise berechnete Normierungsfaktor N wird nachfolgend mit dem Inhalt des ersten Speicherelementes 127a zum Zeitpunkt n mit Hilfe einer Multiplikationseinrichtung 127c multipliziert, um auf diese Weise das kompensierte digitalisierte Messsignal M zu erhalten. Das ebenfalls in der Korrektureinrichtung 127 vorgesehene Verzögerungselement 127e dient dazu, die Aufschaltung des Inhaltes des ersten Speicherelementes 127a auf die Multiplikationseinrichtung 127c so lange zu verzögern, bis der zugehörige Normierungsfaktor N berechnet worden ist.

Die bisher gemachten Aussagen zum Aufbau des elektronischen Schaltkreises gemäß Figur 1 und zum Aufbau der Korrektureinrichtung 127 gemäß Figur 2 betreffen alle Ausführungsbeispiele der Erfindung gleichermaßen.

Nachfolgend werden die Unterschiede zwischen den einzelnen Ausführungsbeispielen des Schaltkreises näher beschrieben.

So zeigt Figur 1 einen elektronischen Schaltkreises, genauer gesagt ein erstes Ausführungsbeispiel zur Bereitstellung des Spannungssignals U, welches die Ungenauigkeit x1 der ersten Versorgungsspannung VS1 repräsentiert. Für den Fall, dass die erste Versorgungsspannung VS1 betraglich größer als die zweite Versorgungsspannung VS2 ist, sieht das in Figur 1 gezeigte erste Ausführungsbeispiel vor, dass das Spannungssignal U mit Hilfe eines vorzugsweise hoch genauen Spannungsteilers R1, R2 realisiert wird, der zwischen die erste Versorgungsspannung VS1 und Masse geschaltet ist. Das Spannungssignal U wird dabei an der Verbindung 140 zwischen den in Reihe geschalteten Widerständen oder Impedanzen R1, R2 zunächst in analoger Form abgegriffen. Das analoge Spannungssignal wird nachfolgend durch einen zweiten Analog/Digital-Wandler 122 in das Spannungssignal U digitalisiert. An dieser Stelle ist es wichtig, darauf hinzuweisen, dass sowohl das analoge wie auch das digitalisierte Spannungssignal die Ungenauigkeit x1 der ersten Versorgungsspannung VS1 repräsentiert. Es ist weiterhin wichtig zu beachten, dass der zweite Analog/Digital-Wandler 122 genau wie der erste Analog/Digital-Wandler 121 mit der zweiten Versorgungsspannung VS2, welche eine Ungenauigkeit von x2 aufweist, betrieben wird. Das auf diese Weise berechnete digitalisierte Spannungssignal U wird nachfolgend in die Korrekt.ureinrichtung 127, genauer gesagt in das zweite Speicherelement 127b eingelesen und dann wie oben unter Bezugnahme auf Figur 2 beschrieben, weiter verarbeitet. Neben dem soeben beschriebenen Ausführungsbeispiel zur Erzeugung des Spannungssignals U beschreibt Figur 1 ein Ausführungsbeispiel zur Realisierung einer Spannungsbegrenzung des von der Sensoreinrichtung 110 bereitgestellten analogen Messsignals. Eine Begrenzung der Amplitude dieses Messsignals ist deswegen erforderlich, weil die erste Versorgungsspannung VS1 als betraglich größer als die zweite Versorgungsspannung VS2 vorausgesetzt wird, mit der die Signalerfassungseinrichtung 120 betrieben wird, in welcher das analoge Messsignal weiter verarbeitet werden soll. Gemäß dem Ausführungsbeispiel erfolgt die Spannungsbegrenzung durch eine der Sensoreinrichtung 110 zugeordnete Kennlinienbegrenzungseinrichtung 112. In der Verbindungsleitung zwischen dem Ausgang der Sensoreinrichtung 110 und dem ersten Analog/Digital-Wandler 121 ist dann in der Regel lediglich ein Widerstand R zur Strombegrenzung oder zur Impedanzanpassung erforderlich.

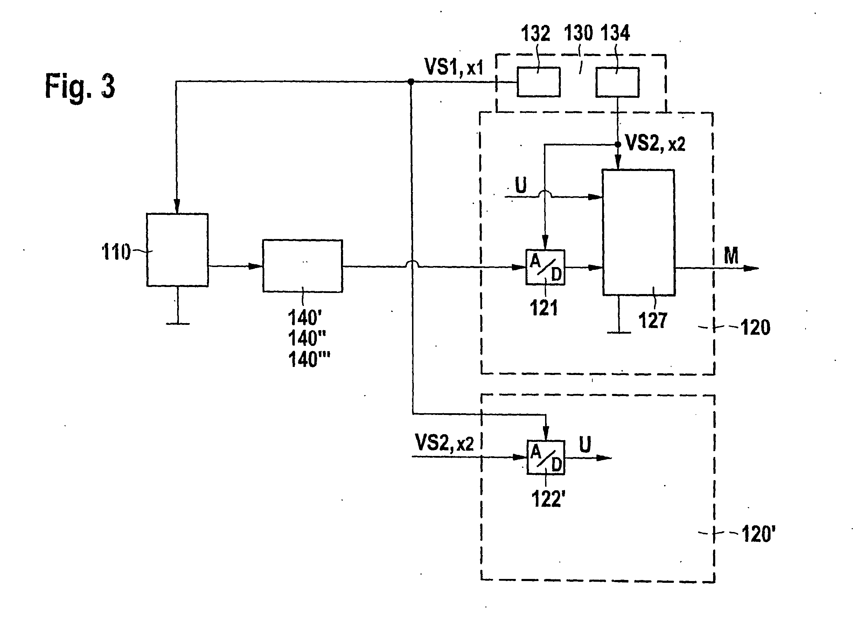

Figur 3 zeigt ein Ausführungsbeispiel des Erfindung zur Bereitstellung des digitalisierten Spannungssignals U und ein zweites Ausführungsbeispiel zur Realisierung der erforderlichen Spannungsbegrenzung für das analoge Messsignal.

Gemäß Figur 3 kann das digitalisierte Spannungssignal U auch in der Weise realisiert werden, dass die zweite Versorgungsspannung VS2 mit der Ungenauigkeit x2 mit Hilfe eines zweiten Analog/Digital-Wandlers 122' digitalisiert wird. Dabei ist es wichtig, dass dieser zweite Analog/Digital-Wandler 122' mit der ersten Versorgungsspannung VS1, welche die Ungenauigkeit x1 aufweist, betrieben wird. Der zweite Analog/Digital-Wandler kann zum Beispiel in einer zweiten Signalerfassungseinrichtung 120' vorgesehen sein, wobei diese zweite Signalerfassungseinrichtung vorzugsweise zusammen mit der ersten Signalerfassungseinrichtung 120 in dem Steuergerät integriert ist. Dieses zweite Ausführungsbeispiel zur Realisierung des digitalisierten Spannungssignals U bietet den Vorteil, dass mit dem zweiten Analog/Digital-Wandler 122' auf eine eventuell ohnehin vorhandene Komponente zurückgegriffen werden kann und dann auf den relativ teuren, weil hoch präzisen Spannungsteiler R1, R2 verzichtet werden kann.

Weiterhin offenbart Figur 3 eine alternative Möglichkeit zur Realisierung der Spannungsbegrenzung des analogen Messsignals. Gemäß Figur 3 erfolgt diese Begrenzung durch ein zwischen dem Ausgang der Sensoreinrichtung 110 und dem Eingang des Analog/Digital-Wandlers 121 vorgesehene Teilerschaltung 140. Bei diesem zweiten Ausführungsbeispiel ist die gemäß dem ersten Ausführungsbeispiel vorgesehene Kennlinienbegrenzung 112 grundsätzlich entbehrlich.

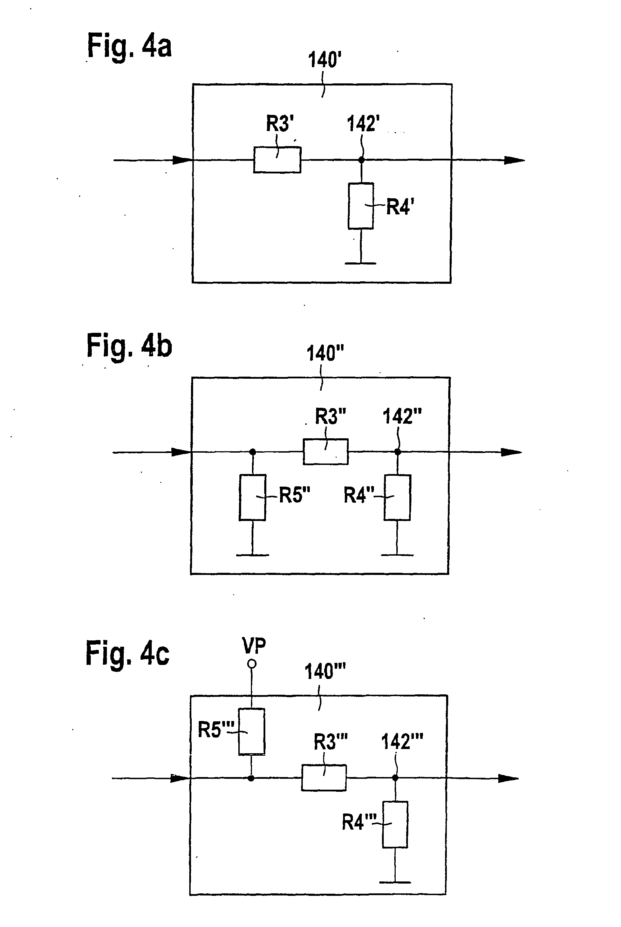

Die Figuren 4a, 4b und 4c zeigen verschiedene Varianten für die Ausgestaltung der Spannungsteilerschaltung 140.

So zeigt Figur 4a eine erste Variante, bei welcher die Spannungsteilerschaltung 140 lediglich einen einfachen Spannungsteiler bestehend aus den Widerständen R3' und R4' aufweist. Diese beiden Widerstände R3' und R4' sind gegenüber dem Ausgang der Sensoreinrichtung 110 in Reihe nach Masse geschaltet. Sie sind so dimensioniert, dass an ihrem Mittelabgriff 142' die geteilte analoge Messspannung abgreifbar ist, deren Maximalamplitude betraglich der zweiten Versorgungsspannung VS2 entspricht. Anstelle dieser beiden separaten Widerstände R3' und R4' kann selbstverständlich auch ein einstückiger Widerstand mit Mittelabgriff verwendet werden. Dies bietet Vorteile bei der Tolerierung beziehungsweise bei der Genauigkeit des Abgriffs.

Bei einer in Figur 4b gezeigten zweiten Variante zur Ausgestaltung der Spannungsteilerschaltung 140" haben die Widerstände beziehungsweise Impedanzen R3'', R4" dieselbe Funktion wie die Widerstände R3' und R4' bei der ersten Variante. Im Unterschied zur ersten Variante sieht die zweite Variante jedoch zusätzlich einen parallel zum Ausgang der Sensoreinrichtung 110 geschalteten Widerstand R5" vor. Dieser dient zur Impedanzanpassung.

Für Sensoreinrichtungen, deren Ausgangsstufe mit einem Pull-up-Widerstand betrieben werden müssen, ist die dritte Variante für die Spannungsteilereinrichtung 140''' vorgesehen. Auch hier erfüllen die Widerstände R3''' und R4''' dieselbe Spannungsteilerfunktion wie sie bereits oben unter Bezugnahme auf die Variante 1 beschrieben wurde. Zusätzlich ist jedoch ein Pull-up-Widerstand R5''' vorgesehen, welcher mit seinem einen Ende zwischen den Ausgang der Sensoreinrichtung 110 und den Widerstand R3''' und mit seinem anderen Ende an eine Spannung VP, zum Beispiel VS1, gelegt ist.

Die Spannungsbegrenzung, sei es in Form der Kennlinienbegrenzungseinrichtung 112 oder in Form einer der Varianten für die Spannungsteilerschaltung 140, ermöglicht, dass die bisherigen Sensoreinrichtungen mit ihrem bisherigen Versorgungsspannungsniveau auch weiterhin verwendet werden können, wenn die Signalerfassungseinrichtungen mit einem niedrigeren Versorgungsspannungsniveau betrieben werden.

Der oben beschriebene Aufbau beziehungsweise die soeben beschriebene Funktionsweise der Korrektureinrichtung 127 wird vorzugsweise mit Hilfe eines Computerprogramms realisiert. Dieses Computerprogramm besitzt vorzugsweise einen Programmcode, welcher geeignet ist, das beschriebene Verfahren zur Kompensation des digitalen Messsignals durchzuführen, wenn er auf einer Recheneinrichtung, insbesondere einem Mikrocontroller eines Steuergerätes ausgeführt wird. Der Programmcode umfasst dann insbesondere die Berechnung des Normierungsfaktors N aus den Inhalten des ersten und des zweiten Speicherelements 127a, 127b zum Zeitpunkt n sowie die nachfolgende Multiplikation des Normierungsfaktors N mit dem Inhalt des ersten Speicherelementes 127a zum Zeitpunkt n. Im Falle einer solchen Softwarerealisierung ist es möglich, dass das Computerprogramm beziehungsweise der Programmcode gegebenenfalls zusammen mit weiteren Computerprogrammen für die Signalerfassungseinrichtung auf einem computerlesbaren Datenträger abgespeichert ist. Bei dem Datenträger kann es sich um eine Diskette, eine Compact-Disc (sogenannte CD) einen Flash-Memory, ein EPROM oder ein EEPROM handeln. Das auf dem Datenträger abgespeicherte Computerprogramm kann dann als Produkt an einen Kunden verkauft werden. Außerdem ist es im Fall einer Softwarerealisierung möglich, dass der Programmcode gegebenenfalls zusammen mit weiteren Computerprogrammen ohne die Zuhilfenahme eines Datenträgers über ein elektronisches Kommunikationsnetzwerk, insbesondere das Internet an einen Kunden übertragen und verkauft wird.

**Patentansprüche**

1. Elektronischer Schaltkreis zur Messgrößenerfassung, umfassend:

   - mindestens eine Sensoreinrichtung (110) zum Bereitstellen eines analogen Messsignals, welches eine von der Sensoreinrichtung (110) erfasste Messgröße repräsentiert;
   - eine erste Signalerfassungseinrichtung (120) mit einem ersten Analogl Digital-Wandler (121) zum Digitalisieren des analogen Messsignals; und
   - eine Spannungsversorgungseinrichtung (130) mit einer ersten Spannungsquelle (132) zum Bereitstellen einer ersten Versorgungsspannung (VS1) für die Sensoreinrichtung (110) mit einer Ungenauigkeit x1 und mit einer zweiten Spannungsquelle (134) zum Bereitstellen einer zweiten Versorgungsspannung (VS2) für die Signalerfassungseinrichtung (120) mit einer Ungenauigkeit x2; wobei sich die Ungenauigkeiten x1, x2 auf das Messsignal übertragen,
   - eine zweite, mit der ersten Versorgungsspannung (VS1) betriebenen Signalerfassungseinrichtung (120'), umfassend einen zweiten Analog/Digital-Wandler (122') zum Erzeugen des die Ungenauigkeit x1 der ersten Versorgungsspannung (VS1) und des die Ungenauigkeit x2 der zweiten Versorgungsspannung (VS2) repräsentierenden Spannungssignals (U) durch Digitalisieren der zweiten Versorgungsspannung (VS2), wobei der zweite Analog/DigitalWandler (122') ebenfalls mit der ersten Versorgungsspannung (VS1) betrieben wird, und
   - die erste Signalerfassungseinrichtung (120) eine Korrektureinrichtung (127) aufweist zum Kompensieren der Auswirkungen der Ungenauigkeiten x1 und x2 auf das digitalisierte Messsignal im Ansprechen auf das digitalisierte, die Ungenauigkeit x 1 der ersten Versorgungsspannung repräsentierendes Spannungssignal (U) und zum Ausgeben eines aus der Kompensation resultierenden kompensierten digitalisierten Messsignals (M).

2. Elektronischer Schaltkreis nach Anspruch 1, **dadurch gekennzeichnet, dass** die Korrektureinrichtung (127) aufweist:

   - ein erstes Speicherelement (127a) zum Abspeichern von Ausgangswerten des ersten Analog/Digital-Wandlers (121),
   - ein zweites Speicherelement (127b) zum Abspeichern von Werten des digitalisierten Spannungssignals (U),
   - eine Normierungseinrichtung (127d) zum Bereitstellen eines aus den Inhalten der beiden Speicherelemente (127a, 127b) abgeleiteten Normierungsfaktors (N), welcher ein Komplement zu den Ungenauigkeiten x1 und/ oder x2 repräsentiert; und
   - eine Multiplikationseinrichtung (127c) zum Erzeugen des kompensierten digitalisierten Messsignals (M) durch Multiplizieren des Inhaltes des ersten Speicherelementes (127a) mit dem Normierungsfaktor N, wobei der Inhalt des ersten Speicherelementes um die Zeitdauer, welche für die Berechnung des Normierungsfaktors N durch ein Verzögerungselement (127e) verzögert auf die Multiplikationseinrichtung (127c) gegeben wird.

3. Elektronischer Schaltkreis nach Anspruch 2, **dadurch gekennzeichnet, dass** der Normierungsfaktor N von der Normierungseinrichtung (127d) wie folgt berechnet wird:

$$N = \text{Inhalt des ersten Speicherelementes/Inhalt des zweiten Speicherelementes.}$$

4. Elektronischer Schaltkreis nach einem der vorangegangenen Ansprüche, **gekennzeichnet dadurch, dass** wenn die erste Versorgungsspannung (VS1) größer als die zweite Versorgungsspannung (VS2) ist eine erste Spannungsteilerschaltung (R1, R2) zum Erzeugen des die Ungenauigkeit x1 der ersten Versorgungsspannung (VS1) repräsentierenden Spannungssignals (U) durch Teilen der ersten Versorgungsspannung (VS1), vorzugsweise in einem solchen Verhältnis, dass das Spannungssignal (U) betraglich der zweiten Versorgungsspannung (VS2) entspricht; und einen zweiten, mit der zweiten Versorgungsspannung (VS2) betriebenen Analog[Digital-Wandler (122) zum Digitalisieren des Spannungssignals (U), wobei der zweite Analog/Digital-Wandler (122) vorzugsweise der Signalerfassungseinrichtung (120) zugeordnet ist.

5. Elektronischer Schaltkreis nach einem der vorangegangenen Ansprüche, **dadurch gekennzeichnet, dass** - wenn die erste Versorgungsspannung (VS 1) größer als die zweite Versorgungsspannung (VS2) ist - die Sensoreinrichtung (110) eine Kennlinienbegrenzungseinrichtung (112) aufweist zum Begrenzen der Ausgangsspannung der Sensoreinrichtung (110) auf den Betrag der zweiten Versorgungsspannung (VS2).

6. Elektronischer Schaltkreis nach einem der Ansprüche 1 bis 4, **gekennzeichnet durch** eine zweite Spannungsteilerschaltung (140', 140" und 140"') zum Teilen des von der Sensoreinrichtung (110) bereitgestellten Messsignals, bevor dieses auf den ersten Analog/Digital-Wandler (121) ausgegeben wird.

7. Elektronischer Schaltkreis nach Anspruch 6, **dadurch gekennzeichnet, dass** die zweite Spannungsteilerschaltung (140') einen zwischen den Ausgang der Sensoreinrichtung (110) und Masse geschalteten Spannungsteiler (R3', R4') aufweist, von dem ein Abgriff (142') auf den Eingang des ersten Analog/Digital-Wandlers (121) der Signalerfassungseinrichtung (120) geschaltet ist.

8. Elektronischer Schaltkreis nach Anspruch 6, **dadurch gekennzeichnet, dass** die zweite Spannungsteilerschaltung (140") eine zwischen den Ausgang der Sensoreinrichtung (110) und Masse geschaltete Pull-down-Impedanz (R5") und parallel dazu einen Spannungsteiler (R3", R4") aufweist, von dem ein Abgriff (142") auf den Eingang des ersten Analog/Digital-Wandlers (121) geschaltet ist.

9. Elektronischer Schaltkreis nach Anspruch 6, **dadurch gekennzeichnet, dass** die zweite Spannungsteilerschaltung (140"') einen zwischen den Ausgang der Sensoreinrichtung (110) und die erste Versorgungsspannung (VS1) geschalteten Pull-up-Widerstand (R5"') und einen zwischen den Ausgang der Sensoreinrichtung (110) und Masse geschalteten Spannungsteiler (R3"', R4"') aufweist, von dem ein Abgriff (142"') auf den Eingang des ersten Analog/Digital-Wandlers (121) der Signalerfassungseinrichtung (120) geschaltet ist.

**Claims**

1. Electronic circuit for measurement variable recording, comprising:

   - at least one sensor device (110) for providing an analogue measurement signal which represents a measurement variable recorded by the sensor device (110);
   - a first signal recording device (120) having a first analogue/digital converter (121) for digitizing the analogue measurement signal; and
   - a voltage supply device (130) having a first voltage source (132) for providing a first supply voltage (VS1) for the sensor device (110) with an inaccuracy of x1 and having a second voltage source (134) for providing a second supply voltage (VS2) for the signal recording device (120) with an inaccuracy of x2, the inaccuracies x1, x2 being applied to the measurement signal,
   - a second signal recording device (120') which is operated with the first supply voltage (VS1) and comprises a second analogue/digital converter (122') for generating the voltage signal (U) which represents the inaccuracy x1 of the first supply voltage (VS1) and the voltage signal (U) which represents the inaccuracy x2 of the second supply voltage (VS2) by digitizing the second supply voltage (VS2), the second analogue/digital converter (122') likewise being operated with the first supply voltage (VS1), and
   - the first signal recording device (120) having a correction device (127) for compensating for the effects of the inaccuracies x1 and x2 on the digitized measurement signal in response to the digitized voltage signal (U), which represents the inaccuracy x1 of the first supply voltage, and for outputting a compensated digitized measurement signal (M) which results from the compensation.

2. Electronic circuit according to Claim 1, **characterized in that** the correction device (127) has:

   - a first memory element (127a) for storing output values of the first analogue/digital converter (121),
   - a second memory element (127b) for storing values of the digitized voltage signal (U),
   - a normalization device (127d) for providing a normalization factor (N) which is derived from the contents of the two memory elements (127a, 127b) and represents a complement to the inaccuracies x1 and/or x2; and
   - a multiplication device (127c) for generating the compensated digitized measurement signal (M) by multiplying the contents of the first memory element (127a) by the normalization factor N, the contents of the first memory element being passed to the multiplication device (127c) after being delayed by a delay element (127e) by the period of time needed to calculate the normalization factor N.

3. Electronic circuit according to Claim 2, **characterized in that** the normalization factor N is calculated by the normalization device (127d) as follows:

```
        N = contents of the first memory element/contents
    of the second memory element.
```

4. Electronic circuit according to one of the preceding claims, **characterized by**, when the first supply voltage (VS1) is greater than the second supply voltage (VS2), a first voltage divider circuit (R1, R2) for generating the voltage signal (U), which represents the inaccuracy x1 of the first supply voltage (VS1), by dividing the first supply voltage (VS1), preferably in a ratio such that the magnitude of the voltage signal (U) corresponds to that of the second supply voltage (VS2), and a second analogue/digital converter (122) which is operated with the second supply voltage (VS2) and is intended to digitize the voltage signal (U), the second analogue/digital converter (122) preferably being assigned to the signal recording device (120).

5. Electronic circuit according to one of the preceding claims, **characterized in that**, when the first supply voltage (VS1) is greater than the second supply voltage (VS2), the sensor device (110) has a characteristic curve limitation device (112) for limiting the output voltage of the sensor device (110) to the magnitude of the second supply voltage (VS2).

6. Electronic circuit according to one of Claims 1 to 4, **characterized by** a second voltage divider circuit (140', 140" and 140"') for dividing the measurement signal provided by the sensor device (110) before said signal is output to the first analogue/digital converter (121).

7. Electronic circuit according to Claim 6, **characterized in that** the second voltage divider circuit (140') has a voltage divider (R3', R4') which is connected between the output of the sensor device (110) and earth and a tap (142') of which is connected to the input of the first analogue/digital converter (121) of the signal recording device (120).

8. Electronic circuit according to Claim 6, **characterized in that** the second voltage divider circuit (140") has a pull-down impedance (R5"), which is connected between the output of the sensor device (110) and earth, and, parallel to said impedance, a voltage divider (R3", R4"), a tap (142") of which is connected to the input of the first analogue/digital converter (121).

9. Electronic circuit according to Claim 6, **characterized in that** the second voltage divider circuit (140"') has a pull-up impedance (R5"'), which is connected between the output of the sensor device (110) and the first supply voltage (VS1), and a voltage divider (R3"', R4"') which is connected between the output of the sensor device (110) and earth and a tap (142"') of which is connected to the input of the first analogue/digital converter (121) of the signal recording device (120).

**Revendications**

1. Circuit électronique pour l'acquisition de grandeurs mesurées comprenant :

   - au moins un dispositif de détection (110) pour délivrer un signal de mesure analogique qui représente une grandeur mesurée acquise par le dispositif de détection (110) ;
   - un premier dispositif d'acquisition de signal (120) comprenant un premier convertisseur analogique/numérique (121) pour numériser le signal de mesure analogique ; et
   - un dispositif d'alimentation électrique (130) comprenant une première source de tension (132) destinée à délivrer une première tension d'alimentation (VS1) pour le dispositif de détection (110) avec une imprécision x1 et comprenant une deuxième source de tension (134) destinée à délivrer une deuxième tension d'alimentation (VS2) pour le dispositif d'acquisition de signal (120) avec une imprécision x2, les imprécisions x1, x2 étant reportées sur le signal de mesure ;
   - un deuxième dispositif d'acquisition de signal (120'), alimenté par la première tension d'alimentation (VS1), comprenant un deuxième convertisseur analogique/numérique (122') pour générer le signal de tension (U) qui représente l'imprécision x1 de la première tension d'alimentation (VS1) et l'imprécision x2 de la deuxième tension d'alimentation (VS2) par numérisation de la deuxième tension d'alimentation (VS2), le deuxième convertisseur analogique/numérique (122') étant lui aussi alimenté par la première tension d'alimentation (VS1) ;
- le premier dispositif d'acquisition de signal (120) comprenant un dispositif de correction (127) pour compenser les effets des imprécisions x1 et x2 sur le signal de mesure numérisé en réaction au signal de tension (U) numérisé représentant l'imprécision x1 de la première tension d'alimentation et pour délivrer un signal de mesure numérisé compensé (M) résultant de la compensation.

**2.** Circuit électronique selon la revendication 1, **caractérisé en ce que** le dispositif de correction (127) présente :

- un premier élément de mémoire (127a) pour enregistrer les valeurs initiales du premier convertisseur analogique/numérique (121),
- un deuxième élément de mémoire (127b) pour enregistrer les valeurs du signal de tension numérisé (U),
- un dispositif de cadrage (127d) pour délivrer un facteur de cadrage (N) dérivé du contenu des deux éléments de mémoire (127a, 127b), lequel représente un complément aux imprécisions x1 et/ou x2 ; et
- un dispositif de multiplication (127c) pour générer le signal de mesure numérisé compensé (M) en multipliant le contenu du premier élément de mémoire (127a) par le facteur de cadrage N, le contenu du premier élément de mémoire étant appliqué au dispositif de multiplication (127c) en étant retardé par un élément de retard (127e) de la durée du calcul du facteur de cadrage N.

**3.** Circuit électronique selon la revendication 2, **caractérisé en ce que** le facteur de cadrage N est calculé comme suit par le dispositif de cadrage (127d) :

```
N = contenu du premier élément de mémoire / contenu du
    deuxième élément de mémoire
```

**4.** Circuit électronique selon l'une des revendications précédentes, **caractérisé par**, lorsque la première tension d'alimentation (VS1) est supérieure à la deuxième tension d'alimentation (VS2), un premier circuit diviseur de tension (R1, R2) destiné à générer le signal de tension (U) représentant l'imprécision x1 de la première tension d'alimentation (VS1) en divisant la première tension d'alimentation (VS1) de préférence dans un rapport tel que la valeur absolue du signal de tension (U) correspond à celle de la deuxième tension d'alimentation (VS2) ; et un deuxième convertisseur analogique/numérique (122) alimenté par la deuxième tension d'alimentation (VS2) et destiné à numériser le signal de tension (U), le deuxième convertisseur analogique/numérique (122) étant de préférence associé au dispositif d'acquisition du signal (120).

**5.** Circuit électronique selon l'une des revendications précédentes, **caractérisé en ce que** lorsque la première tension d'alimentation (VS1) est supérieure à la deuxième tension d'alimentation (VS2), le dispositif de détection (110) présente un dispositif de limitation de la courbe caractéristique (112) pour limiter la tension de sortie du dispositif de détection (110) à la valeur de la deuxième tension d'alimentation (VS2).

**6.** Circuit électronique selon l'une des revendications 1 à 4, **caractérisé par** un deuxième circuit diviseur de tension (140', 140" et 140''') destiné à diviser le signal de mesure délivré par le dispositif de détection (110) avant que celui-ci soit appliqué au premier convertisseur analogique/numérique (121).

**7.** Circuit électronique selon la revendication 6, **caractérisé en ce que** le deuxième circuit diviseur de tension (140') présente un diviseur de tension (R3', R4') branché entre la sortie du dispositif de détection (110) et la masse et dont une prise (142') est connectée à l'entrée du premier convertisseur analogique/numérique (121) du dispositif d'acquisition de signal (120).

**8.** Circuit électronique selon la revendication 6, **caractérisé en ce que** le deuxième circuit diviseur de tension (140") présente une impédance de tirage à la masse (R5") connectée entre la sortie du dispositif de détection (110) et la masse et parallèlement à celle-ci un diviseur de tension (R3", R4") dont une prise (142") est connectée à l'entrée du premier convertisseur analogique/numérique (121).

**9.** Circuit électronique selon la revendication 6, **caractérisé en ce que** le deuxième circuit diviseur de tension (140''') présente une résistance de tirage au positif (R5''') connectée entre la sortie du dispositif de détection (110) et la première tension d'alimentation (VS1) ainsi qu'un diviseur de tension (R3''', R4''') branché entre la sortie du dispositif de détection (110) et la masse, dont une prise (142''') est connectée à l'entrée du premier convertisseur analogique/numérique (121) du dispositif d'acquisition de signal (120).

Fig. 1

# Fig. 2

**Fig. 3**

## Fig. 4a

140'

R3'    142'

R4'

## Fig. 4b

140"

R3"    142"

R5"    R4"

## Fig. 4c

VP

140'''

R5''''

R3'''    142'''

R4''''

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4220012 A1
- DE 19629747 A1